# EUROPÄISCHE PATENTSCHRIFT

(11) **EP 3 069 379 B1**
(45) Veröffentlichungstag und Bekanntmachung des Hinweises auf die Patenterteilung: **12.03.2025**
(21) Anmeldenummer: 14809605.0
(22) Anmeldetag: 17.11.2014
(51) Int. Cl.: H01L 21/67, H01L 21/677, H01L 21/68, H01L 21/683

(54) **VORRICHTUNG ZUM ENTLEEREN EINES TRANSPORTBEHÄLTERS**
DEVICE FOR EMPTYING A TRANSPORT CONTAINER
DISPOSITIF DESTINÉ À VIDANGER UN RÉCIPIENT DE TRANSPORT

(30) Priorität: 15.11.2013 EP 13193220
(43) Veröffentlichungstag der Anmeldung: 21.09.2016
(73) Patentinhaber: mechatronic Systemtechnik GmbH, 9586 Fürnitz (AT)
(72) Erfinder: OREMUS, Alexander, A-9500 Villach (AT); GLANTSCHNIG, Arno, A-9065 Reichersdorf (AT)
(74) Vertreter: Jell, Friedrich
(86) Internationale Anmeldenummer: PCT/EP2014/074814
(87) Internationale Veröffentlichungsnummer: WO 2015/071475

(56) Entgegenhaltungen:
- WO-A1-01/03893
- WO-A1-2004/019387
- WO-A1-2007/058693
- WO-A1-2008/117928
- WO-A1-2011/010683
- WO-A2-2009/074297
- DE-A1- 102012 102 239
- US-A1- 2006 090 848
- US-B1- 6 345 818

## Beschreibung

### Technisches Gebiet

Die Erfindung betrifft eine Vorrichtung zum Entleeren eines Transportbehälters, der einen Stapel an plattenförmigen Gegenständen, umfassend Halbleiterwafer und/oder Verpackungsmaterial, aufweist, mit mindestens einer Messeinrichtung, mit einem in den Transportbehälter zumindest teilweise einfahrbaren Halter, der eine Haltefläche, mehrere Haltedüsen zum wenigstens Halten eines Gegenstands des Stapels und im Bereich der Haltefläche zumindest eine Ausnehmung für die Messeinrichtung zur Messdatenerfassung vom Gegenstand des Stapels aufweist.

### Stand der Technik

Aus dem Stand der Technik sind Vorrichtungen mit Düsen zum Aufnehmen von Substraten bekannt, die Meßeinrichtungen aufweisen (WO01/03893A1, WO2008/145085A1). So beschreibt WO2008/145085A1 eine Vorrichtung mit einem Halter, einer Haltefläche mit Düsen zur Ausbildung des Bernoulli-Effekts, um damit Halbleiterwafer aufnehmen, und mit einer Messeinrichtung. Die Messeinrichtung ist ein kapazitiver Sensor, der durch einen Bereich der Haltefläche ragt, um die korrekte Aufnahme des angesaugten Halbleiterwafers zu erkennen. Nachteilig ist an dieser Vorrichtung, dass sie nicht in der Lage ist, sowohl Halbleiterwafer als auch Verpackungsmaterial, beispielsweise Folien, Papier oder Kunststoffschaum, korrekt aufzunehmen. Dies stellt insbesondere ein Problem dar, wenn die Vorrichtung Halbleiterwafer greifen muss, die für den Transport zu einem Stapel verpackt sind. Diese Problematik erhöht sich zunehmend, als am Halbleiterwafer durch Adhäsionskräfte Verpackungsmaterial haften bleiben kann, was einem stückweisen Entleeren des Transportbehälters entgegensteht. Zudem kann beim Entleeren eine Beschädigung der Halbleiterwafer nicht ausgeschlossen werden, wenn beispielsweise Halbleiterwafer bei der Entnahme vom Stapel mitgezogen und dann auf den Stapel zurückfallen bzw. anderswo vom Halter abfallen.

Zudem ist zum Separieren von gestapelten Halbleiterwafern bekannt (DE102012102239A1), eine Separierdüse zu verwenden, die auf eine Stirnseite des Substratstapels eine gerichtete Gasströmung ausbildet. Die Separierdüse kann alternativ zum Anheben des Stapels bei einem stationären Stapel abgesenkt werden, um damit der verminderten Stapelhöhe zu folgen, die sich daraus ergibt, wenn ein Halter mit Saugdüsen ein Substrat vom Stapel abgehoben hat. Eine derartige Konstruktion mit einer beweglichen Separierdüse oder beweglichen Stapel bedarf bei Haltern mit Saugdüsen nachteilig einer exakte Steuerung und Ausrichtung von Separierdüse zum Stapel, um nicht die Funktion der Saugdüsen des Halters durch die Gasströmung der Separierdüse zu stören. US6345818 B1 offenbart eine Vorrichtung zum Entleeren eines Transportbehäters gemäß dem Oberbegriff des Anspruchs 1.

### Darstellung der Erfindung

Der Erfindung liegt somit die Aufgabe zugrunde, ausgehend vom eingangs geschilderten Stand der Technik, eine konstruktiv einfach ausgebildete Vorrichtung zu schaffen, die für ein sicheres Entleeren eines Transportbehälters mit Halbleiterwafer geeignet ist.

Die Erfindung löst die gestellte Aufgabe durch eine Vorrichtung nach Anspruch 1.

Weist der Halter mindestens eine außerhalb der Haltefläche derart von einer Ruhelage in eine Separierlage beweglich am Halter angeordnete Separierdüse auf, dass sich in der Separierlage der Separierdüse eine auf die Stirnseite des Stapels gerichtete Gasströmung ausbildet, kann damit unabhängig von Parametern des Stapels, insbesondere dessen Stapelhöhe, etc. sichergestellt werden, dass ein am vom Halter gehaltenen Gegenstand anhaftender anderer Gegenstand des Stapels nicht vom Halter mitgenommen wird. Die am Halter beweglich angeordnete Separierdüse bewegt sich nämlich mit dem Halter zum aufzunehmenden Gegenstand des Stapels mit, wodurch diese mit dem Halter mitpositionierte Separierdüse die geforderte Separierlage stets einnehmen kann. Durch den gegenüber dem aufzunehmenden Gegenstand in Raum positionierten Halter kann nämlich die Lage der Separierdüse zum Stapel im Raum äußerst genau bestimmt werden. Dies kann weiter verbessert werden, da mit der Messeinrichtung Daten zur Verfügung stehen, die bei zum Gegenstand positioniertem Halter zur genaueren Einstellung der Separierlage der Separierdüse berücksichtigt werden können. Die Standfestigkeit des Halters kann dadurch deutlich verbessert werden. Damit kann sichergestellt werden, dass ein vom Stapel aufgenommener bzw. gehaltener Gegenstand frei von anhaftenden anderen Gegenständen des Stapels ist, und das unabhängig von der Stapelhöhe und/oder Stapellage. Die präzise gerichtete Gasströmung kann nämlich Adhäsionskräfte zwischen den Gegenständen des Stapels stets überwinden und so ein stückweises Abheben von Gegenständen des Stapels gewährleisten. Die erfindungsgemäße Vorrichtung ist daher für ein sicheres Entleeren eines Transportbehälters mit Halbleiterwafer besonders geeignet ist. Verpackungsmaterial, beispielsweise Folien, Papier, Kunststoffschaum oder dergleichen, können somit sicher vom Halbleiterwafer getrennt werden. Zudem können damit auch die Halbleiterwafer von Beschädigungen geschützt werden, die sich durch eine Mitnahme anderer entnommener Gegenstände ergeben können. Eine konstruktiv einfach ausgeführte, dennoch besonders robust und standfest im Entleeren eines Transportbehälters ausgebildete Vorrichtung kann somit geschaffen werden.

Im Allgemeinen wird erwähnt, dass die Vorrichtung nicht auf Transportbehälter für Halbleiterwafer und Verpackungsmaterial beschränkt ist, vielmehr können auch andere Gegenstände in diesen Stapeln vorgesehen sein.

Die Erfindung kann konstruktiv vereinfacht werden, wenn der Halter zumindest einen pneumatischen Zylinder aufweist, der mit der Separierdüse verbunden ist, um diese zu verlagern bzw. von deren Ruhelage in die Separierlage und wieder zurückzubewegen.

Sind die Separierdüse und der pneumatische Zylinder mit einer gemeinsamen Druckluftleitung verbunden, können sich weitere konstruktive Vereinfachungen und damit Kosteneinsparungen ergeben. Das Arbeitsmedium der Separierdüsen kann nämlich auch für den pneumatischen Zylinder verwendet werden, wodurch sich eine kostengünstigere Vorrichtung ergeben kann. Ist zudem der Staudruck an der Separierdüse entsprechend groß, dass bei diesem der pneumatische Zylinder noch in seiner Arbeitsstellung - entsprechend der Separierlage der Düse - gehalten wird, können Separierdüse und pneumatischer Zylinder vereinfacht über ein gemeinsames Ventil angesteuert werden. Zudem können durch geeignete Dimensionierung von Düse und Zylinder stoßweise Gasströmungen mit gleichzeitiger Bewegung des Zylinders und damit der Separierdüse realisiert werden. Damit kann sich die Möglichkeit ergeben, eine besonders effektive Separierung zwischen dem vom Halter gehaltenen Gegenstand und dem anhaftenden anderen Gegenstand des Stapels zu erreichen.

Ist zwischen Halter und mindestens einer Separierdüse eine erste Führung, zur Verlagerung der Separierdüse von der Ruhe- in die Separierlage und wieder zurück vorgesehen, können die Separierdüsen besonders präzise bewegt werden. Eine Linearführung kann sich hiefür als besonders gut geeignet auszeichnen.

Die Separierdüse ist in der Ruhelage hinter und in der Separierlage vor der Haltefläche angeordnet, kann dies die Funktion der Vorrichtung erheblich erleichtern. So kann eine zurückgezogene Separierdüse beispielsweise ein Ein- und Ausfahren des Halters bzw. die Positionierung des Halters im Transportbehälter erleichtern. Außerdem kann sich aufgrund der möglichen Vermeidung der Haltefläche vorspringender Teile die Gefahr einer Beschädigung der gestapelten Gegenstände durch den Halter vermindern.

Vorteilhaft zum sicheren Halten der Gegenstände kann sich erweisen, wenn die Haltedüsen mehrere Bernoullidüsen an der Haltefläche und mehrere Vakuumdüsen im Randbereich der Haltefläche aufweisen. Dabei kann eine getrennte Ansteuerung bzw. Betätigung dieser Bernoullidüsen und Vakuumdüsen von Vorteil sein. Damit kann es ermöglicht werden, unterschiedliche Greif- und Haltevorgänge mit ein und derselben Vorrichtung durchzuführen. So können zum Beispiel die Bernoullidüsen zum Greifen des obersten Gegenstands des Stapels benutzt werden, und die Vakuumdüsen erst aktiviert werden, wenn der Gegenstand an der Haltefläche liegt. Natürlich sind auch Anwendungen vorstellbar, wo zuerst die Vakuumdüsen oder wo Vakuumdüsen und Bernoullidüsen gleichzeitig eingeschaltet werden. Besonders vorteilhaft kann unter Umständen eine Vorrichtung sein, die mehrere getrennt ansteuerbare Gruppen von Düsen aufweist, wobei die einzelnen Gruppen von Düsen ringförmig an der Haltefläche angeordnet sind. So kann mithilfe der verschieden angesteuerten Düsengruppen der Separiervorgang des anhaftenden Gegenstands noch weiter begünstigt werden.

Ist zwischen den Vakuumdüsen und dem Halter eine zweite Führung zum Verlagern der Vakuumdüsen in eine der Haltefläche vorstehende Greiflage vorgesehen, kann sich die erfindungsgemäße Vorrichtung zur Aufnahme unterschiedlichster Gegenstände bewähren. So können beispielsweise die beweglich gelagerten Vakuumdüsen in Richtung des zu greifenden Gegenstands verlagert werden, um diesen festzuhalten. Werden die Bernoullidüsen an der Haltefläche zur Erzeugung eines Unterdrucks mit einem Fluid beaufschlagt, kann der zu greifende Gegenstand zugleich durch den Unterdruck an die Haltefläche angezogen werden. Mit einer eintretenden Wölbung des so gehaltenen Gegenstands kann ein darunter liegender, anhaftender und steiferer Gegenstand teilweise abgelöst werden. Dies kann insbesondere zum Lösen von Papier vom Halbleiterwafer genutzt werden, wodurch selbst filigrane Gegenstände vom Stapel sicher gegriffen sowie einzeln abgehoben werden können. Im Allgemeinen wird erwähnt, dass auch bei den geführten Vakuumdüsen ein Zurückverlagern der Vakuumdüsen in eine höchstens plane Lage mit der Haltefläche die Handhabung der Vorrichtung unbeeinträchtigt bleiben kann, weil sich damit auskragende Teile, die bei Bewegung der Vorrichtung zu berücksichtigen wären, vermeiden lassen.

Diese Vorteile können weiter verbessert werden, indem mittig an der Haltefläche mindestens eine Bernoullidüse vorgesehen ist, da sich dadurch der Unterdruck zum Aufnehmen des Gegenstands in der Mitte der Haltefläche deutlicher ausprägen und sich in weiterer Folge eine besonders günstige Wölbung am aufzunehmenden Gegenstand ausbilden kann.

Weist die Messeinrichtung eine erste Einrichtung zur Abstandsmessung, insbesondere Laserabstandsmessung, zwischen Haltefläche und aufzunehmendem Gegenstand auf, kann damit der Abstand zwischen diesen schnell und genau bestimmt werden - indem die Abstandsmessung mit dem Halter mitbewegt wird. Infolgedessen kann damit der Halter in die optimale Position für den Aufnahmevorgang bzw. für die Erfassung von Daten vom aufzunehmenden Gegenstand gebracht werden. Zudem können mithilfe dieser genauen Positionserfassung der Halter und damit die Separierdüsen so gesteuert werden, dass sich die gegen die Stirnseite des Stapels gerichtete Gasströmung in der richtigen Höhe, nämlich zwischen aufzunehmendem Gegenstand und dem daran haftenden Gegenstand des Stapels, ausbilden kann.

Damit ist die Möglichkeit geschaffen, den Separiervorgang noch effektiver und sicherer zu gestalten.

Weist die Messeinrichtung eine zweite Einrichtung mit einem Bildsensor zur Erfassung von Bilddaten vom aufzunehmenden Gegenstand auf, kann aufgrund der erhaltenen Bilddaten der aufzunehmende Gegenstand des Stapels genau identifiziert werden, was eine erhöhte Sicherheit in der Bestimmung der Art des aufzunehmenden Gegenstands gegeben kann, als dies von kapazitiven Sensoren bekannt ist. Für einen kapazitiven Sensor ist es beispielsweise kaum möglich, den Unterschied zwischen einem Halbleiterwafer und einem Halbleiterwafer auf dem eine 80µm dünne Papierschicht, ein als Interleave bezeichnetes Verpackungsmaterial, liegt, zu erkennen. Erst durch die Erfassung von Bilddaten kann die genaue Unterscheidung zwischen verschiedenem Verpackungsmaterial und Halbleiterwafer möglich werden. Zudem können sich im Zusammenspiel mit der ersten Einrichtung zur Abstandsmessung Vorteile bei der zweiten Einrichtung zur Erfassung von Bilddaten ergeben, indem durch eine genaue Abstandsmessung verbessert auf den Gegenstand fokussiert werden kann. Die Bilddatenerfassung kann dadurch erheblich genauer durchgeführt werden. Im Allgemeinen wird festgehalten, dass die Auswertung der Bilddaten sowohl in der Einrichtung zur Erfassung von Bilddaten als auch in einer externen Steuereinrichtung, welche die gesamte Vorrichtung steuert, erfolgen kann. So kann zum Beispiel schon durch eine einfache Auswertung des gemittelten RGB Wertes der Bilddaten auf die Farbe des Gegenstands rückgeschlossen werden. Abhängig von den zu unterscheidenden Gegenständen des Stapels kann dies eventuell alleine schon ein ausreichendes Unterscheidungsmerkmal sein. Zudem kann bei genügend großer Auflösung der Bilddaten auch auf die Oberflächenstruktur des Gegenstands rückgeschlossen werden, wodurch ein weiteres Unterscheidungsmerkmal ermittelbar ist. Denkbar ist auch die Verwendung einer Einrichtung zur Erfassung von Bilddaten, die einen Lernmodus zur Erkennung und Programmierung bestimmter Materialen aufweist. Im Betrieb kann die Einrichtung, den eingelegten, aufgrund von Oberfläche und Farbe identifizierten Gegenstand, dann zum Beispiel über Digitalausgänge einer Steuerung melden. Somit können die verschiedenen Gegenstände des Stapels (Halbleiterwafer, Papier, Folie, Kunststoffschaum etc.) richtig erkannt und dementsprechend korrekt aufgenommen, separiert und gehalten werden.

Nehmen die erste und zweite Einrichtung über die gemeinsame Öffnung im Halter Mess- und Bilddaten auf, kann sich dies aufgrund eines reduzierten Ausschnitts an der Haltefläche vorteilhaft auf die Greif- und Halteeigenschaften der Vorrichtung auswirken. Der zu haltende Gegenstand kann damit nämlich mithilfe der Haltedüsen stabiler und damit standfester an der Vorrichtung gehalten werden. Im Allgemeinen sei erwähnt, dass die Messung der verschiedenen Sensoren durch eine Öffnung sequenziell aber auch parallel erfolgen kann. Die Wahl der geeigneteren Methode kann von einer möglichen gegenseitigen Beeinflussung der Sensoren aber auch der Leistung der Steuerung der Vorrichtung abhängig sein.

Nimmt zumindest eine der Messeinrichtungen die Mess- und/oder Bilddaten über einen Umlenkspiegel auf, kann die jeweilige Messeinrichtung parallel zur Ausrichtung der Haltefläche eingebaut werden, was eine kompaktere Bauform der Vorrichtung erlauben kann. Im Allgemeinen wird erwähnt, dass bei entsprechender Miniaturisierung der Messeinrichtungen natürlich auch ein direkter Einbau der Messeinrichtung in den Halter denkbar ist.

Weist die Messeinrichtung einen in einer Öffnung vorgesehenen kapazitiven Sensor auf, kann das erfolgreiche Aufnehmen und Halten eines Gegenstands überwacht werden.

Wird in Abhängigkeit der Messdatenerfassung der Messeinrichtung vom Gegenstand des Stapels die Separierlage der Separierdüse eingestellt kann, das Separieren von anhafteten Gegenständen noch weiter verbessert werden. So kann beispielsweise mit einem Erkennen des Wafers auf dessen Dicke ruckgeschlossen und damit die Separierlage der Separierdüse angepasst werden.

### Kurze Beschreibung der Zeichnung

In den Figuren ist beispielsweise der Erfindungsgegenstand anhand einer Ausführungsvariante näher dargestellt. Es zeigen
- Fig. 1: eine Vorderansicht der Vorrichtung mit teilweise aufgerissenem Transportbehälter
- Fig. 2: eine Ansicht der Vorrichtung von unten
- Fig. 3: eine teilweise aufgerissene Vorderansicht der Vorrichtung mit den Düsen in Separier- und Greiflage und mit teilweise aufgerissenem Transportbehälter und
- Fig. 4: einen vergrößerten Ausschnitt der Düsen in Separier- und Greiflage der Fig. 3.

### Weg zur Ausführung der Erfindung

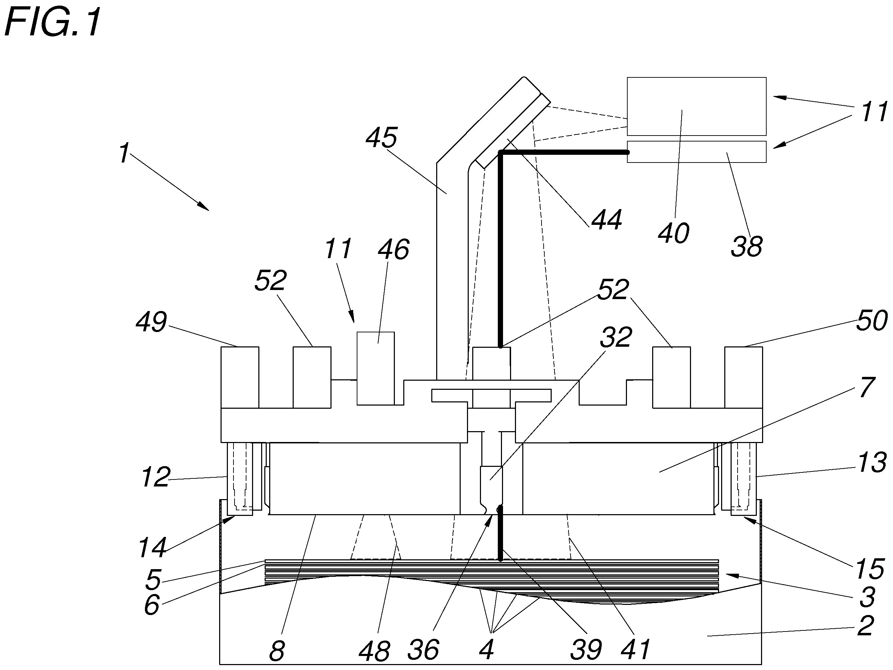

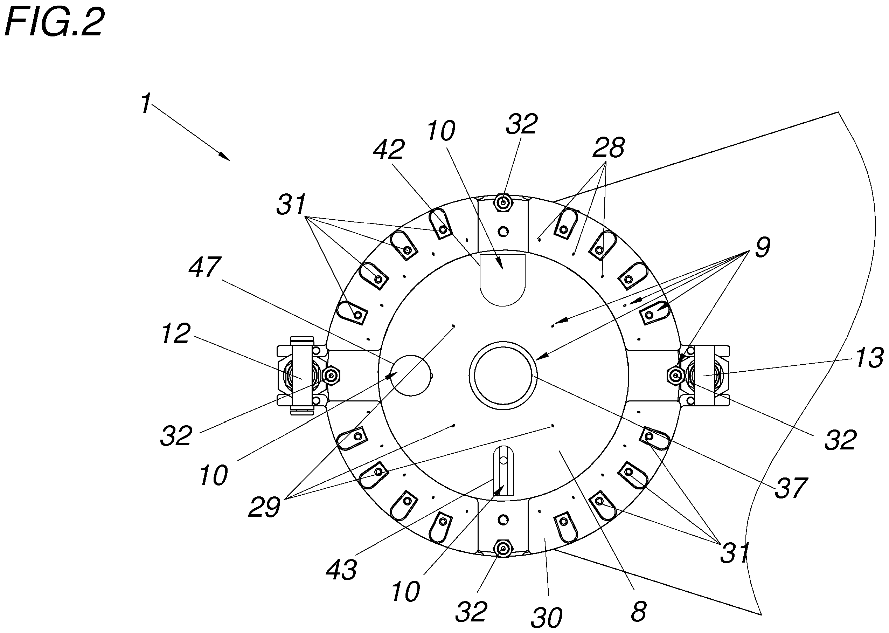

Gemäß Fig. 1 wird eine Vorderansicht einer beispielsweisen Vorrichtung 1 mit einem teilweise aufgerissenen Transportbehälter 2 gezeigt. In dem Transportbehälter 2 befindet sich ein zylindrischer Stapel 3 von runden und plattenförmigen Gegenständen 4. Die Gegenstände 4 sind verpackte Halbleiterwafer 5 und Verpackungsmaterial 6 die alternierend in einem Transportbehälter 2 gestapelt sind. Zudem weist die Vorrichtung 1 einen Halter 7 auf, auf dessen Haltefläche 8 mehrere Haltedüsen 9 - wie in Fig. 2 zu sehen - angeordnet sind. Im Bereich der Haltefläche 8 ist eine Ausnehmung 10 zur Aufnahme einer Messeinrichtung 11 vorgesehen, die für die Erfassung von Messdaten eines Gegenstands 4 des Stapels 3 zuständig ist.

Erfindungsgemäß sind zwei diametral angeordnete, beweglich gelagerte Separierdüsen 12, 13 vorgesehen, die erfindungsgemäß außerhalb der Haltefläche 8 am Halter 7 angeordnet sind, um damit ein stückweises Entleeren des Transportbehälters 2 sicherzustellen. Vorteilhaft hierzu ist eine linear bewegliche Lagerung der Separierdüsen 12, 13 vorgesehen, deren Ruhelage 14, 15 in Fig. 1 dargestellt ist.

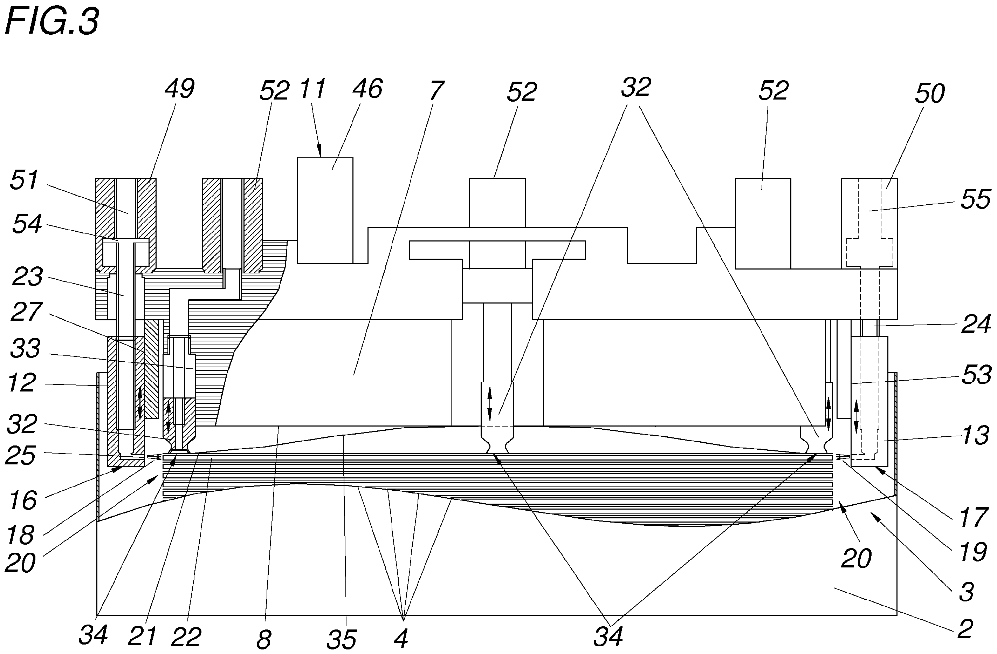

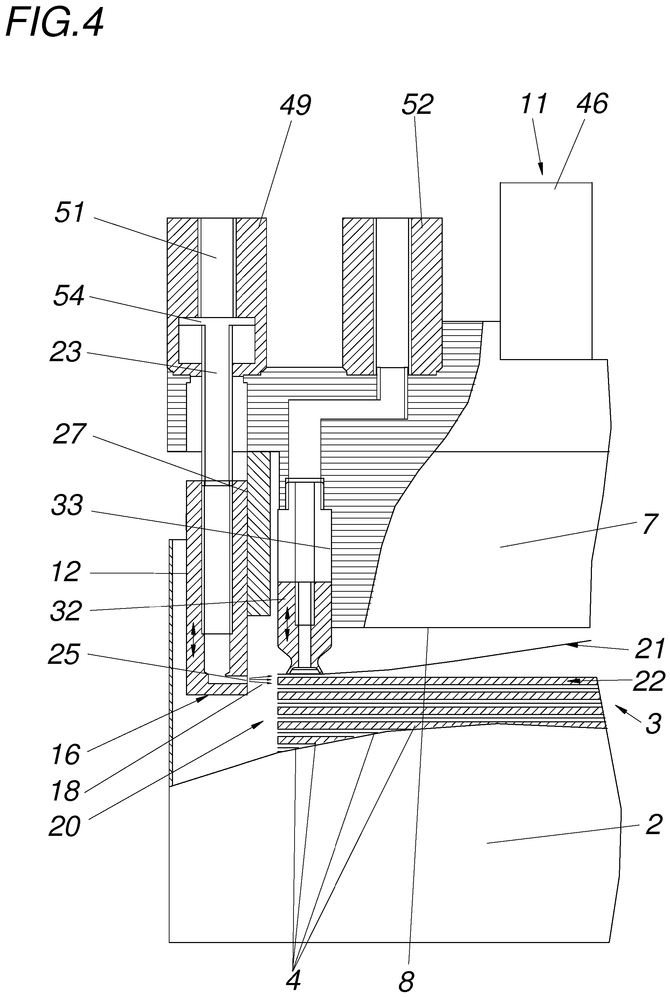

Entsprechend den Fig. 3 bzw. Fig. 4 sind die Separierdüsen 12, 13 in der Separierlage 16, 17 zu erkennen, wobei sie Gasströmungen 18, 19 in Richtung Stirnseite 20 des Stapels 3 ausbilden. Die Gasströmungen 18, 19 in Richtung der Stirnseite 20 des Stapels 3 können zwischen vom Halter 7 gehaltenen Gegenstand 21 und des daran anhaftenden anderen Gegenstands 22 des Stapels 3 eindringen. Dementsprechend werden die Adhäsionskräfte zwischen den Gegenständen 21, 22 des Stapels 3 mithilfe dieser Gasströmungen 18, 19 in den Separierlagen 16, 17 der Separierdüsen 12, 13 überwunden. Durch diese bewirkte Loslösung der beiden Gegenstände 21, 22 voneinander kann die Vorrichtung 1 das erfindungsgemäße Aufnehmen und Halten eines Gegenstands 21 vom Stapel 3 der Transportbox 2 durchführen, ohne unbeabsichtigt einen anhaftenden Gegenstand 22 mitzuhalten bzw. damit in weiterer Folge Halbleiterwafer 5 eventuell mitzureißen und damit zu beschädigen. Zudem ist das Einnehmen der Separierlagen 16, 17 der Separierdüsen 12, 13 einfach und damit standfest, weil durch den gegenüber dem aufzunehmenden Gegenstand 21 in Raum positionierten Halter 7 die Lage der Separierdüsen 12, 13 zum Stapel 3 im Raum äußerst genau bestimmt ist. Auch wird die Messdatenerfassung der Messeinrichtung 11 vom obersten Gegenstand 21 des Stapels 3 verwendet, die Separierlagen 16, 17 der Separierdüse 12, 13 noch genauer einzustellen, beispielsweise über eine nicht näher dargestellten Steuerung am Halter 7, die mit der Messeinrichtung 11 datenverbunden ist.

Gemäß Fig. 3 bzw. Fig. 4 weist die Vorrichtung pneumatische Zylinder 23, 24 zur Verlagerung der Separierdüsen 12, 13 von der Ruhelage 14, 15 in die Separierlage 16, 17 auf. Da die Separierdüsen 12, 13 ohnehin zur erfindungsgemäßen Lösung der Aufgabe eine Gasströmung 18, 19 ausbilden, müssen sie dementsprechend mit einem Gas über die Druckluftanschlüsse 49, 50 versorgt werden. Dieses kann zugleich auch als Arbeitsmedium für die pneumatischen Zylinder 23, 24 verwendet werden. Solche Synergieeffekte bewirken meist Einsparungen und damit eine kostengünstigere Vorrichtung 1.

Wie in Fig 4 dargestellt, werden weitere Synergieeffekte erzielt, wenn die Separierdüse 12 und und der pneumatischen Zylinder 23 mit einer gemeinsamen Druckluftleitung 51 verbunden sind. So ist der pneumatische Zylinder 23 nach unten offen und speist gleichzeitig die Düsenmündung 25. Voraussetzung dafür ist, dass der Staudruck an der Düsenmündung 25 derart groß ist, dass bei diesem der pneumatische Zylinder 23 noch in seiner Arbeitsstellung - entsprechend der Separierlage 16 der Separierdüse 12 - gehalten wird. Separierdüse 12 und pneumatischer Zylinder 23 werden damit konstruktiv vereinfach durch ein gemeinsames Ventil 54 angesteuert. Neben den Kosten reduzierenden Effekten auf die Vorrichtung 1 sind durch diese Anordnung bei geeigneter Dimensionierung von Düsenmündung 25 und Zylinder 23 stoßweise Gasströmungen mit gleichzeitiger Bewegung der Separierdüse 12 auf einfache und elegante Weise realisiert. Damit kann eine besonders wirksame Loslösung zwischen dem vom Halter 7 gehaltenen Gegenstand 21 und dem anhaftenden anderen Gegenstand 22 des Stapels 3 erreicht werden.

Die Linearführungen 27, 53 dienen zur Verlagerung der Separierdüse 12, 13 von der Ruhelage 14, 15 in die Separierlage 16, 17 und wieder zurück. Dementsprechend können die Separierdüsen 12, 13 in der Ruhelage 14, 15 in eine vom Halter 7 verdeckte Lage einfahren. Das erleichtert bzw. ermöglicht problemlos das teilweise Ein- und Ausfahren des Halters 7 in die Transportbox 2 und auch das Aufnehmen der bodennahen Gegenstände 4 des Stapels 3, weil Auskragungen von der Haltefläche 8 vermieden werden.

Gemäß Fig. 2 wird die Ansicht der Vorrichtung 1 von unten gezeigt. An der Haltefläche 8 sind die Haltedüsen 9 in getrennt ansteuerbaren Gruppen von Düsen 28, 29, 31, 32 aufgeteilt, wobei die einzelnen Gruppen von Düsen 28, 29, 31, 32 ringförmig angeordnet sind. Bei dem gezeigten Ausführungsbeispiel sind im inneren Bereich der Haltefläche 8 mehrere Bernoullidüsen 28, 29 in Gruppen und im Randbereich 30 Vakuumdüsen 31, 32 in Gruppen. Mittels dieser Düsenkonfiguration können unterschiedliche Greif- und Haltevorgänge durchgeführt werden. Abhängig vom obersten Gegenstand 21 des Stapels 3 können zum Beispiel die Bernoullidüsen 28, 29 zum Greifen benutzt werden, und die Vakuumdüsen 31, 32 zum Halten des Gegenstands. Die erfindungsgemäße Separierung wird zudem weiter verbessert, indem abhängig vom obersten Gegenstand 4 des Stapels 3 Düsengruppen zeitlich unterschiedlich angesteuert werden. Wie den Figuren 1 und 3 entnommen werden kann, werden die Vakuumdüsen 32 über die Anschlüsse 52 versorgt.

Gemäß Fig. 4 ist erkennbar, dass die Vakuumdüsen 32 auf Führungen 33 beweglich gelagert sind. Mit deren Hilfe können die Vakuumdüsen 32 in eine von der Haltefläche 8 vorstehende Greiflage 34 verlagert werden. Diese Greiflage 34 zeichnet sich besonders zum Aufnehmen eines dünnen Gegenstands 21, beispielsweise von Papier, des Stapels 3 aus, da dieser im Randbereich gemäß Fig. 3 mit den Vakuumdüsen 32 auf Abstand vom Halter 7 gehalten werden kann. Werden die Bernoullidüsen 28, 29 an der Haltefläche 8 zur Erzeugung eines Unterdrucks aktiviert, wird der zu greifende Gegenstand 21 zugleich durch den Unterdruck an die Haltefläche 8 angezogen und durch die beweglich gelagerten Vakuumdüsen 32 in der Greiflage 34 von der Haltefläche 8 auf Abstand gehalten. Durch diese Druckverhältnisse tritt an einem dünnen zu greifenden Gegenstand 21 eine Wölbung 35 auf, die eine teilweise Loslösung des darunterliegenden eventuell auch haftenden Gegenstands 22 bewirkt. Sind nun zusätzlich die beweglich gelagerten Separierdüsen 12, 13 in ihrer Separierlage 16, 17 und bilden sie eine Gasströmung 18, 19 in Richtung Stirnseite 20 des Stapels 3 aus, werden aufzunehmender Gegenstand 21 und daran anhaftender, darunterliegender Gegenstand 22 einfach voneinander getrennt - die beweglich gelagerten Vakuumdüsen 32 werden in ihre Ausgangslage 36 entsprechend Fig. 1 zurückverlagert.

Gemäß Fig. 2 ist ein weiterer Kreis von Bernoullidüsen 37 mittig an der Haltefläche 8 vorgesehen. Mit deren Hilfe kann sich die Wölbung 35 gegen die Mitte des aufzunehmenden Gegenstands 21 deutlicher ausprägen und die Separierung nochmals vereinfachen bzw. verbessern.

Gemäß Fig. 1 weist die Messeinrichtung 11 eine Laserabstandsmessung 38 auf. Mit dieser wird der Abstand 39 zwischen Halter 7 und aufzunehmendem Gegenstand 21 bestimmt. Damit ist eine genaue Positionierung der Vorrichtung 1 für den Aufnahmevorgang bzw. für die Erfassung von Daten vom aufzunehmenden Gegenstand 21 gegeben. Besonders wichtig ist die genaue Abstandsmessung 38 für die exakte Positionierung des Halters 7 im Zusammenspiel mit den Separierdüsen 12, 13 in Separierlage 16, 17. So kann nämlich sichergestellt werden, dass die Gasströmungen 18, 19 in der richtigen Höhe, also entsprechend zwischen aufzunehmendem Gegenstand 21 und dem daran haftenden Gegenstand 22 des Stapels 3, auf die Stirnseite 20 des Stapels 3 treffen.

Außerdem ist in Fig. 1 an der Messeinrichtung 11 eine zweite Einrichtung 40, nämlich mit einem Bildsensor zur Erfassung von Bilddaten 41 vom aufzunehmenden Gegenstand 21, zu erkennen. Mit den aufgenommenen Bilddaten 41 wird der oberste Gegenstand 21 des Stapels 3 identifiziert und diese Information für den Greif- und Haltevorgang genutzt. Somit kann die Vorrichtung automatisch, abhängig vom obersten Gegenstand 21 des Stapels 3, mit der bestmögliche Ansteuerung der Separierdüsen 12, 13 und Haltedüsen 9 betrieben werden. Zudem funktioniert die Erfassung von Bilddaten 41 im Zusammenspiel mit der Laserabstandsmessung 38 besonders vorteilhaft, denn durch die genaue Abstandsmessung 38 kann die Einrichtung 40 zur Erfassung von Bilddaten 41 optimal auf den Gegenstand 21 fokussieren und so aussagekräftigere Bilddaten 41 erfassen.

Wie in Fig. 1 dargestellt, nehmen die Laserabstandsmessung 38 und Bildsensor 40 über eine gemeinsame Öffnung 42 im Halter 7 Mess- 39 und Bilddaten 41 auf. Dadurch ist in weiterer Folge die verbleibende Haltefläche 8 größer, womit ein stabileres Halten des Gegenstandes 21 erreicht wird. Für den Fall, dass sich die Messeinrichtungen 11 gegenseitig nachteilig beeinflussen sollten, ist die Messung natürlich auch über eine weitere optionale Öffnung 43, wie in Fig. 2 strichliert gezeigt, denkbar.

Der in Fig. 1 gezeigte Umlenkspiegel 44, der auf einer Spiegelhalterung 45 befestigt ist, erlaubt die Anordnung der Messeinrichtungen 11 parallel zur Ausrichtung der Haltefläche 8. Somit kann eine kompaktere Bauweise der Vorrichtung 1 erreicht werden.

Gemäß Fig 1. weist die Messeinrichtung 11 zusätzlich einen kapazitiven Sensor 46 in einer Öffnung 47 auf. Der kapazitive Sensor 46 ermittelt Messdaten 48, die auf das erfolgreiche Aufnehmen und Halten eines Gegenstands 21 rückschließen lassen, und dient zur Überwachung des Greif- und Haltevorgangs.

## Patentansprüche

1. Vorrichtung zum Entleeren eines Transportbehälters (2), der einen Stapel (3) an plattenförmigen Gegenständen (4), umfassend Halbleiterwafer (5) und/oder Verpackungsmaterial (6), aufweist, mit mindestens einer Messeinrichtung (11) zur Messdatenerfassung vom Gegenstand (4) des Stapels (3), und mit einem in den Transportbehälter (2) zumindest teilweise einfahrbaren Halter (7), der eine Haltefläche (8), mehrere Haltedüsen (9) zum wenigstens Halten eines Gegenstands (4) des Stapels (3) und im Bereich der Haltefläche (8) zumindest eine Ausnehmung (10) für die Messeinrichtung (11) zur Messdatenerfassung vom Gegenstand (4) des Stapels (3) aufweist, wobei der Halter (7) mindestens eine außerhalb der Haltefläche (8) derart von einer Ruhelage (14, 15) in eine Separierlage (16, 17) beweglich am Halter (7) angeordnete Separierdüse (12, 13) aufweist, und wobei sich in der Separierlage (16, 17) der Separierdüse (12, 13) eine auf die Stirnseite (20) des Stapels (3) gerichtete Gasströmung (18, 19) ausbildet, um damit mindestens einen am vom Halter (7) gehaltenen Gegenstand (21) anhaftenden anderen Gegenstand (22) des Stapels (3) zu lösen, **dadurch gekennzeichnet, dass** die Separierdüse (12, 13) in der Ruhelage (14, 15) hinter und in der Separierlage (16, 17) vor der Haltefläche (8) angeordnet ist.

2. Vorrichtung nach Anspruch 1, **dadurch gekennzeichnet, dass** der Halter (7) zumindest einen pneumatischen Zylinder (23, 24) aufweist, der mit der Separierdüse (12, 13) zu deren Verlagerung verbunden ist.

3. Vorrichtung nach Anspruch 2, **dadurch gekennzeichnet, dass** die Separierdüse (12, 13) und der pneumatische Zylinder (23, 24) mit einer gemeinsamen Druckluftleitung (51, 55) verbunden sind.

4. Vorrichtung nach Anspruch 1, 2 oder 3, **dadurch gekennzeichnet, dass** zwischen Halter (7) und mindestens einer Separierdüse (12, 13) eine erste Führung (27, 53), insbesondere Linearführung, zur Verlagerung der Separierdüse (12, 13) von der Ruhe- (14, 15) in die Separierlage (16, 17) und wieder zurück vorgesehen ist.

5. Vorrichtung nach einem der Ansprüche 1 bis 4, **dadurch gekennzeichnet, dass** die Haltedüsen (9) mehrere Bernoullidüsen (28, 29) an der Haltefläche (8) und mehrere Vakuumdüsen (31, 32) im Randbereich (30) der Haltefläche (8) aufweisen.

6. Vorrichtung nach Anspruch 5, **dadurch gekennzeichnet, dass** zwischen den Vakuumdüsen (32) und dem Halter (7) eine zweite Führung (33) zum Verlagern der Vakuumdüsen (32) in eine der Haltefläche (8) vorstehende Greiflage (34) vorgesehen ist.

7. Vorrichtung nach Anspruch 5 oder 6, **dadurch gekennzeichnet, dass** mittig an der Haltefläche (8) mindestens eine Bernoullidüse (37) vorgesehen ist.

8. Vorrichtung nach einem der Ansprüche 1 bis 7, **dadurch gekennzeichnet, dass** die Messeinrichtung (11) eine erste Einrichtung zur Abstandsmessung (38), insbesondere Laserabstandsmessung, zwischen Haltefläche (8) und aufzunehmendem Gegenstand (21) aufweist.

9. Vorrichtung nach einem der Ansprüche 1 bis 8, **dadurch gekennzeichnet, dass** die Messeinrichtung (11) eine zweite Einrichtung (40) mit einem Bildsensor zur Erfassung von Bilddaten (41) vom aufzunehmenden Gegenstand (21) aufweist.

10. Vorrichtung nach Anspruch 8 und 9, **dadurch gekennzeichnet, dass** die erste und zweite Einrichtung (38, 40) über die gemeinsame Öffnung (42) im Halter (7) Mess- und Bilddaten (39, 41) aufnehmen.

11. Vorrichtung nach einem der Ansprüche 8 bis 10, **dadurch gekennzeichnet, dass** zumindest eine der Messeinrichtungen (38, 40) die Mess- und/oder Bilddaten (39, 41) über einen Umlenkspiegel (44) aufnimmt.

12. Vorrichtung nach einem der Ansprüche 1 bis 11, **dadurch gekennzeichnet, dass** die Messeinrichtung (11) einen in einer Öffnung (47) vorgesehenen kapazitiven Sensor (46) aufweist.

13. Vorrichtung nach einem der Ansprüche 1 bis 12, **dadurch gekennzeichnet, dass** in Abhängigkeit der Messdatenerfassung der Messeinrichtung (11) vom Gegenstand (21) des Stapels (3) die Separierlage (16, 17) der Separierdüse (12, 13) eingestellt wird.

## Claims

1. Apparatus for emptying a transport container (2), which is provided with a stack (3) of plate-shaped objects (4) comprising semiconductor wafers (5) and/or packaging material (6), with at least one measuring device (11) for acquisition of measured data from the object (4) of the stack (3) for acquisition of measured data from the object (4) of the stack (3), and with a holder (7), which can be inserted at least partly into the transport container (2) and which is provided with a holding surface (8), several holding nozzles (9) for at least holding an object (4) of the stack (3) and, in the region of the holding surface (8), at least one recess (10) for the measuring device (11) for acquisition of measured data from the object (4) of the stack (3), wherein the holder (7) is provided with at least one separating nozzle (12, 13), disposed on the holder (7) outside the holding surface (8) so as to be movable from a resting position (14, 15) into a separating position (16, 17), wherein in the separating position (16, 17), the separating nozzle (12, 13) generates a gas stream (18, 19) directed onto the end face (20) of the stack (3), in order to loosen at least one other object (22) of the stack (3) adhering to the object (21) held by the holder (7), **characterized in that** the separating nozzle (12, 13) is arranged behind the holding surface (8) in the resting position (14, 15) and in front of the holding surface (8) in the separating position (16, 17).

2. Apparatus according to claim 1, **characterized in that** the holder (7) is provided with at least one pneumatic cylinder (23, 24), which is connected to the separating nozzle (12, 13) in order to displace it.

3. Apparatus according to claim 2, **characterized in that** the separating nozzle (12, 13) and the pneumatic cylinder (23, 24) are connected to a common compressed-air line (51, 55).

4. Apparatus according to claim 1, 2, or 3, **characterized in that** a first guide (27, 53), more particularly linear guide, for displacement of the separating nozzle (12, 13) from the resting position (14, 15) into the separating position (16, 17) and back is provided between holder (7) and at least one separating nozzle (12, 13).

5. Apparatus according to one of claims 1 to 4, **characterized in that** the holding nozzles (9) are provided with several Bernoulli nozzles (28, 29) on the holding surface (8) and several vacuum nozzles (31, 32) in the rim region (30) of the holding surface (8).

6. Apparatus according to claim 5, **characterized in that** a second guide (33) for displacement of the vacuum nozzles (32) is provided between the vacuum nozzles (32) and the holder (7) in a gripping position (34) protruding from the holding surface (8).

7. Apparatus according to claim 5 or 6, **characterized in that** at least one Bernoulli nozzle (37) is provided centrally on the holding surface (8).

8. Apparatus according to one of claims 1 to 7, **characterized in that** the measuring device (11) is provided with a first device for measurement of the distance (38), more particularly laser measurement of the distance, between holding surface (8) and object (21) to be picked up.

9. Apparatus according to one of claims 1 to 8, **characterized in that** the measuring device (11) is provided with a second device (40) having an image sensor for acquisition of image data (41) from the object (21) to be picked up.

10. Apparatus according to claim 8 and 9, **characterized in that** the first and second devices (38, 40) record measured and image data (39, 41) via the common opening (42) in the holder (7).

11. Apparatus according to one of claims 8 to 10, **characterized in that** at least one of the measuring devices (38, 40) records the measured and/or image data (39, 41) via a deflection mirror (44).

12. Apparatus according to one of claims 1 to 11, **characterized in that** the measuring device (11) is equipped with a capacitive sensor (46) provided in an opening (47).

13. Apparatus according to one of claims 1 to 12, **characterized in that** the separating position (16, 17) of the separating nozzle (12, 13) is adjusted as a function of the measured-data acquisition of the measuring device (11) from the object (21) of the stack (3).

## Revendications

1. Dispositif permettant de vider un contenant de transport (2), qui présente une pile (3) d'objets (4) en forme de plaque, comprenant des plaquettes semi-conductrices (5) et/ou du matériel d'emballage (6), avec au moins un dispositif de mesure (11) permettant d'acquérir des données de mesure de l'objet (4) de la pile (3), et avec un dispositif de retenue (7) au moins en partie rétractable dans le contenant de transport (2), qui présente une surface de retenue (8), plusieurs buses de retenue (9) servant au moins à maintenir un objet (4) de la pile (3) et au moins un évidement (10) dans la zone de la surface de retenue (8) pour le dispositif de mesure (11) permettant d'acquérir des données de mesure de l'objet (4) de la pile (3), le dispositif de retenue (7) présentant au moins une buse de séparation (12, 13) agencée sur le dispositif de retenue (7) à l'extérieur de la surface de retenue (8) de manière mobile d'une position de repos (14, 15) à une position de séparation (16, 17), et lorsque la buse de séparation (12, 13) est dans sa position de séparation (16, 17), un flux de gaz (18, 19) orienté sur le côté frontal (20) de la pile (3) étant formé pour ainsi détacher au moins un autre objet (22) de la pile (3) adhérant à l'objet (21) maintenu sur le dispositif de retenue (7), **caractérisé en ce que** la buse de séparation (12, 13) est disposée derrière la surface de retenue (8) dans la position de repos (14, 15) et devant celle-ci dans la position de séparation (16, 17).

2. Dispositif selon la revendication 1, **caractérisé en ce que** le dispositif de retenue (7) présente au moins un vérin pneumatique (23, 24) relié à la buse de séparation (12, 13) pour son déplacement.

3. Dispositif selon la revendication 2, **caractérisé en ce que** la buse de séparation (12, 13) et le vérin pneumatique (23, 24) sont reliés par une conduite d'air comprimé commune (51, 55).

4. Dispositif selon la revendication 1, 2 ou 3, **caractérisé en ce qu'**il est prévu entre le dispositif de retenue (7) et au moins une buse de séparation (12, 13) un premier guidage (27, 53), en particulier un guidage linéaire, pour le déplacement de la buse de séparation (12, 13) de la position de repos (14, 15) à la position de séparation (16, 17) et inversement.

5. Dispositif selon l'une des revendications 1 à 4, **caractérisé en ce que** les buses de retenue (9) présentent plusieurs buses de Bernoulli (28, 29) sur la surface de retenue (8) et plusieurs buses à vide (31, 32) dans la zone de bordure (30) de la surface de retenue (8).

6. Dispositif selon la revendication 5, **caractérisé en ce qu'**il est prévu entre les buses à vide (32) et le dispositif de retenue (7) un deuxième guidage (33) pour le déplacement des buses à vide (32) dans une position de préhension (34) faisant saillie de la surface de retenue (8).

7. Dispositif selon la revendication 5 ou 6, **caractérisé en ce qu'**au moins une buse de Bernoulli (37) est prévue au centre de la surface de retenue (8).

8. Dispositif selon l'une des revendications 1 à 7, **caractérisé en ce que** le dispositif de mesure (11) présente un premier dispositif de mesure de distance (38), en particulier de mesure de distance au laser, entre la surface de retenue (8) et l'objet à enregistrer (21).

9. Dispositif selon l'une des revendications 1 à 8, **caractérisé en ce que** le dispositif de mesure (11) présente un deuxième dispositif (40) avec un capteur d'image permettant d'acquérir des données d'image (41) de l'objet (21) à enregistrer.

10. Dispositif selon la revendication 8 et 9, **caractérisé en ce que** le premier et le deuxième dispositifs (38, 40) enregistrent des données de mesure et d'image (39, 41) par l'intermédiaire de l'ouverture commune (42) dans le dispositif de retenue (7).

11. Dispositif selon l'une des revendications 8 à 10, **caractérisé en ce qu'**au moins l'un des dispositifs de mesure (38, 40) enregistre les données de mesure et/ou d'image (39, 41) par l'intermédiaire d'un miroir de renvoi (44).

12. Dispositif selon l'une des revendications 1 à 11, **caractérisé en ce que** le dispositif de mesure (11) présente un capteur capacitif (46) prévu dans une ouverture (47).

13. Dispositif selon l'une des revendications 1 à 12, **caractérisé en ce que** la position de séparation (16, 17) de la buse de séparation (12, 13) est réglée en fonction de l'acquisition des données de mesure du dispositif de mesure (11) de l'objet (21) de la pile (3).
